(19) Europäisches Patentamt
European Patent Office
Office européen des brevets

(11) Veröffentlichungsnummer: **0 217 205 B1**

# (12) EUROPÄISCHE PATENTSCHRIFT

(45) Veröffentlichungstag der Patentschrift: **11.12.91**

(51) Int. Cl.[5]: **C07C 69/54**, C07C 323/62, C08F 2/50, C09D 11/10, //C07C49/84

(21) Anmeldenummer: **86112676.1**

(22) Anmeldetag: **13.09.86**

## (54) Copolymerisierbare Fotoinitiatoren.

(30) Priorität: **28.09.85 DE 3534645**

(43) Veröffentlichungstag der Anmeldung: **08.04.87 Patentblatt 87/15**

(45) Bekanntmachung des Hinweises auf die Patenterteilung: **11.12.91 Patentblatt 91/50**

(84) Benannte Vertragsstaaten: **AT BE CH DE FR GB IT LI NL SE**

(56) Entgegenhaltungen:
**US-A- 4 469 774**

**CHEMICAL ABSTRACTS, Band 105, 1986, Seite 94, Zusammenfassung Nr. 62300t, Columbus, Ohio, US; & JP-A-61 50 939**

**CHEMICAL ABSTRACTS, Band 82, Nr. 2, 13. Januar 1975, Zusammenfassung Nr. 4613t, Columbus, Ohio, US; N. ITO et al.: "Synthesis and photoreaction of polyacyloinmethacrylates"**

**CHEMICAL ABSTRACTS, Band 68, 1968, Seite 3921, Zusammenfassung Nr. 40151k, Columbus, Ohio, US; K. YASUHIKO et al.: "Synthesis and reactions of reactive polymers. XXV. Synthesis and photoreaction of poly(benzoin acrylate)"**

(73) Patentinhaber: **MERCK PATENT GESELLSCHAFT MIT BESCHRÄNKTER HAFTUNG**
**Frankfurter Strasse 250 Postfach 4119**
**W-6100 Darmstadt(DE)**

(72) Erfinder: **Köhler, Manfred, Dr.**
**Hebbelstrasse 38**
**W-6100 Darmstadt(DE)**
Erfinder: **Ohngemach, Jörg, Dr.**
**Taubenstrasse 6**
**W-6107 Reinheim 5(DE)**
Erfinder: **Poetsch, Eike, Dr.**
**Am Buchwald 4**
**W-6109 Mühltal 6(DE)**

EP 0 217 205 B1

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft copolymerisierbare Fotoinitiatoren für die Fotopolymerisation ethylenisch ungesättigter Verbindungen bzw. solche enthaltender Systeme.

Fotochemisch induzierte Polymerisationsreaktionen haben in der Technik große Bedeutung erlangt, insbesondere wenn es um eine schnelle Härtung von dünnen Schichten geht, wie z. B. bei der Härtung von Lack- und Harzüberzügen auf Papier, Metall und Kunststoff oder bei der Trocknung von Druckfarben, da diese Verfahren sich gegenüber konventionellen Methoden zum Bedrucken und Beschichten von Gegenständen durch Rohstoff- und Energieersparnis und eine geringere Umweltbelastung auszeichnen. Aber auch die Herstellung von Polymermaterialien an sich durch Polymerisation entsprechender ungesättigter monomerer Ausgangsmaterialien erfolgt vielfach fotochemisch, wobei übliche Verfahren wie Lösungs- und Emulsionspolymerisationen zur Anwendung gelangen können.

Da bei den genannten Reaktionen in der Regel keiner der Reaktionspartner in der Lage ist, die fotochemisch wirksame Strahlung in ausreichendem Maße zu absorbieren, müssen sogenannte Fotoinitiatoren zugesetzt werden, die in der Lage sind, entweder eingestrahlte energiereiche Strahlung, meist UV-Licht, zu absorbieren und dabei aktive Starterradikale zu bilden, die ihrerseits die Fotopolymerisation auslösen, oder die aufgenommene Energie zur Radikalbildung auf einen der polymerisierbaren Reaktionspartner zu übertragen. An der eigentlichen Polymerisationsreaktion nehmen die Initiatoren normalerweise nicht teil.

Als Initiatoren für die Fotopolymerisation ungesättigter Verbindungen sind bisher hauptsächlich Benzophenonderivate, Benzoinether, Benzilketale, Dibenzosuberonderivate, Anthrachinone, Xanthone, Thioxanthone, $\alpha$-Halogenacetophenonderivate, Dialkoxyacetophenone und Hydroxyalkylphenone eingesetzt worden.

Wesentliche Kriterien für die Auswahl solcher Initiatoren sind unter anderem die Art der durchzuführenden Reaktionen, das Verhältnis des Absorptionsspektrums des Initiators zur spektralen Energieverteilung der verfügbaren Strahlenquelle, die Wirksamkeit des Initiators, die Löslichkeit des Initiators in der Reaktionsmischung, die Dunkellagerstabilität des mit dem Initiator versetzten Reaktionssystems sowie die Beeinflussung der Endprodukte durch darin verbliebene Reste des Initiators und/oder der daraus während der fotochemischen Reaktion entstandenen Produkte.

Die technische Anwendbarkeit vieler der genannten Substanzen wird jedoch bekanntermaßen durch eine Reihe von Nachteilen zum Teil deutlich eingeschränkt. Hierzu gehört insbesondere die häufig zu geringe Reaktivität im Vermögen, die Fotopolymerisation ethylenisch ungesättigter Verbindungen zu initiieren. Neben molekülspezifischer Reaktivität spielt hierbei vielfach die Löslichkeit bzw. die möglichst gleichmäßige Einarbeitbarkeit der Fotoinitiatoren in den fotopolymerisierbaren Systemen eine entscheidende Rolle.

Als besonders vorteilhaft aufgrund ihrer günstigen Eigenschaften haben sich jedoch die Hydroxyalkylphenone der DE-OS 27 22 264 erwiesen. Diese spezielle Substanzklasse liegt im anwendungstypischen Temperaturbereich im flüssigen Aggregatzustand vor, woraus eine vorzügliche Löslichkeit bzw. homogene Einarbeitbarkeit in den gängigen fotopolymerisierbaren Systemen resultiert. Desweiteren verfügen diese Fotoinitiatoren über eine überdurchschnittliche hohe Aktivität bei gleichzeitig einer ungewöhnlich günstigen Dunkellagerstabilität der damit versetzten Systeme. Trotzdem sind die Hydroxyalkylphenon-Fotoinitiatoren noch verbesserungswürdig.

Da diese wie auch die übrigen gängigen Fotoinitiatoren nicht an der eigentlichen Fotopolymerisation teilnehmen, verbleiben deren überschüssige, unumgesetzte Reste sowie deren während der fotochemischen Reaktion entstandenen Abbauprodukte im fertigen Produkt. Dies kann, je nach Art und Anteil, zu mehr oder weniger ausgeprägten Beeinflussungen der Produkteigenschaften führen. Bei fotopolymerisierten Lackbeschichtungen, dem Hauptanwendungsgebiet für Fotoinitiatoren beispielsweise, können derartige Reste die erzielbare Endhärte der Schicht beeinflussen; desweiteren kann es, oft auch erst nach längerer Zeit, zu unerwünschten Farbveränderungen, beispielsweise Vergilbung kommen. Initiatorreste oder deren Abbauprodukte können sich aufgrund ihrer mehr oder weniger ausgeprägten Flüchtigkeit durch unangenehmen Geruch bemerkbar machen; ihre Diffusion aus der Beschichtung heraus in umgebende Medien kann Probleme schaffen, beispielsweise wenn mit fotopolymerisierten Beschichtungen versehene Verpackungsmaterialien wie etwa Dosen und Tuben für Lebensmittel vorgesehen sind. Gerade in diesem Anwendungsbereich wird die Frage der Verwendbarkeit entscheidend von der möglichen bzw. erwiesenen Toxizität der Fotoinitiatoren sowie ihrer Abbauprodukte bestimmt.

Gemäß dem Stand der Technik sind bestimmte Fotoinitiatoren, die neben anderen auch ungesättigte Substituenten aufweisen, bekannt. Es handelt sich überwiegend hierbei um Benzoin- bzw. Benzilderivate. Außer der Verbindung $\alpha$-Allylbenzoin, das in seiner Initiatorwirkung den Hydroxyalkylphenonen nahe kommt, haben sich derartige ungesättigte Fotoinitiatoren jedoch nicht durchgesetzt, da sie keine wesentlichen Vorteile hinsichtlich Gehalt an unumgesetzten Resten und Abbauprodukten im Polymerprodukt bieten und

ansonsten den Hydroxyalkylphenonen nachstehen.

Chemical Abstracts 1975, 82, 4013t beschreibt mit Azobisisobutyronitril polymerisierte Acyloinmethacrylate. Diese photoempfindlichen Polymermaterialien können als Photosensibilisatoren für Methylmethacrylat verwendet werden.

In Chemical Abstracts 1968, 68, 4015 k wird offenbart, daß aus Benzoinacrylat erhaltende Polymere bzw. Copolymere mit Styrol oder mit Methylmethacrylat unter UV-Einwirkung, gegebenenfalls mit Hilfe weiterer Photosensibilisatoren, zu unlöslichen Produkten wie insbesondere vernetzten Produkten bzw. "graft polymers" umgewandelt werden können.

In US-A-4,469,774 werden polymerisierte Benzoinacrylate beschrieben. Diese Materialien werden in der Photolithographie und Photoresisttechnik angewendet, wobei sie im wesentlichen die schichtbildende Komponente bilden, die in einem Positiv-Prozess der Photostrukturierung unterworfen werden.

Der Erfindung lag somit die Problemstellung zugrunde, Fotoinitiatoren aufzufinden und bereitzustellen, die möglichst so strukturiert sein sollten, etwa durch copolymerisierbare ethylenisch ungesättigte Substituenten, daß sie an der Fotopolymerisationsreaktion direkt teilnehmen und ihre Reste bzw. Abbauprodukte möglichst vollständig in den Polymerverband eingebaut werden. Gleichzeitig sollten ihre sonstigen Eigenschaften wie Initiatorwirkung und Kompatibilität mit üblichen strahlungshärtbaren Systemen den besten der bekannten Fotoinitiatoren zumindest entsprechen.

Überraschend wurde nun gefunden, daß diese Forderungen in hervorragender Weise von den neuen Verbindungen der allgemeinen Formel I

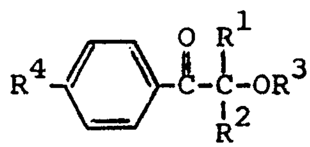

(I)

worin

- $R^1$ und $R^2$ jeweils H, $C_{1-6}$-Alkyl
- $R^3$ H, $C_{1-6}$-Alkyl, $C_{1-6}$-Alkanoyl oder die Gruppe Z,
- $R^4$ H, Halogen, $C_{1-12}$-Alkyl, $C_{1-12}$-Alkoxy, $C_{1-12}$-Alkylthio oder die Gruppe $-x[(CH_2-CH_2-O)_n-Z]_m$

und

- X O, S oder N
- n die Zahlen 0 bis 4,
- m die Zahl 1 für X = O und S oder die Zahlen 1 und 2 für X = N
- Z die Gruppe -CO-CR=CR'R" mit R, R', R" jeweils H oder $CH_3$

bedeuten,
wobei immer mindestens einer der Reste $R^3$ oder $R^4$ die Gruppe Z enthält,
erfüllt werden.

Gegenstand der Erfindung sind somit die neuen Verbindungen der allgemeinen Formel I.

Gegenstand der Erfindung ist außerdem die Verwendung der Verbindungen der Formel I als copolymerisierbare Fotoinitiatoren für die Fotopolymerisation ethylenisch ungesättigter Verbindungen oder solche enthaltender Systeme.

Gegenstand der Erfindung ist weiterhin ein Verfahren zur Fotopolymerisation ethylenisch ungesättigter Verbindungen oder solche enthaltender Systeme, wobei man dem zu polymerisierenden Gemisch vor der Auslösung der Fotopolymerisation mindestens eine Verbindung der Formel I als copolymerisierbaren Fotoinitiator zusetzt.

Gegenstand der Erfindung sind darüber hinaus fotopolymerisierbare Systeme, enthaltend mindestens eine ethylenisch ungesättigte fotopolymerisierbare Verbindung sowie gegebenenfalls weitere bekannte und übliche Zusatzstoffe, wobei diese mindestens eine Verbindung der Formel I als copolymerisierbaren Fotoinitiator enthalten.

Die erfindungsgemäßen Verbindungen der Formel I leiten sich strukturell von den Hydroxyalkylphenon-Fotoinitiatoren ab, enthalten im Gegensatz zu diesen jedoch ethylenisch ungesättigte Gruppen vom Acryloyl-Typ.

Gemäß den oben angegebenen Definitionen für die Formel I ist oder enthält immer mindestens einer der Reste $R^3$ oder $R^4$ die Gruppe Z mit der Struktur -CO-CR=CR'R". R,R' und R" können hierbei jeweils Wasserstoff oder Methyl bedeuten, wobei Acryloyl und Methacryloyl bevorzugt als Gruppe Z in Frage kommen.

Steht in Formel I nur der Rest $R^3$ für die Gruppe Z, so stellen die entsprechenden Verbindungen Veresterungsprodukte der Hydroxyalkylphenone mit Acrylsäure bzw. Acrylsäurederivaten dar. $R^1$ und $R^2$ können dann jeweils Wasserstoff oder $C_{1-6}$-Alkyl, $R^4$ Wasserstoff, Halogen, $C_{1-12}$-Alkyl, -Alkoxy oder -Alkylthio bedeuten.

Bevorzugte Verbindungen sind solche, in denen $R^1$ und $R^2$ Methyl bedeuten.

Entsprechende Fotoinitiatoren sind beispielsweise:

Phenyl-2-acryloyloxy-2-propylketen
Phenyl-2-methacryloyloxy-2-propylketon
(4-Isopropylphenyl)-2-acryloyloxy-2-propylketon
(4-Chlorphenyl)-2-acryloyloxy-2-propylketon
(4-Dodecylphenyl)-2-acryloyloxy-2-propylketon
(4-Methoxyphenyl)-2-acryloyloxy-2-propylketon

Enthält in Formel I der Rest $R^4$ die Gruppe Z, so resultieren Hydroxyalkylphenon-Derivate, die in para-Stellung des Phenylringes ungesättigte Reste vom Acryloyl-Typ tragen. Diese Reste können über ein Sauerstoff-, Schwefel- oder Stickstoffatom und/ oder über eine oder mehrere Oxyethylen-Brücken mit dem Phenylring verknüpft sein. Bevorzugt ist die Verknüpfung über eine Oxyethylen-Brücke.

Die übrigen Substituenten können gemäß den angegebenen Definitionen frei gewählt werden. Bevorzugte Fotoinitiatoren sind solche, in denen $R^1$ und $R^2$ Methyl und $R^3$ Wasserstoff bedeuten.

Als entsprechende Verbindungen sind beispielsweise zu nennen:

(4-Acryloyloxyphenyl)-2-hydroxy-2-propylketon
(4-Methacryloyloxyphenyl)-2-hydroxy-2-propylketon
[4-(2-Acryloyloxyethoxy)-phenyl]-2-hydroxy-2-propylketon
[4-(2-Acryloyloxydiethoxy)phenyl]-2-hydroxy-2-propylketon
4-(2-Acryloyloxyethoxy)-benzoin
[4(2-Acryloyloxyethylthio)-phenyl]-2-hydroxy-2-propylketon
[4-N,N-bis-(2-Acryloyloxyethyl)-aminophenyl]-2-hydroxy-2-propylketon

Vorteilhaft ist es aber auch, wenn in Formel I sowohl der Substituent $R^3$ als auch der Substituent $R^4$ ungesättigter Reste vom Acryloyl-Typ enthalten. Es resultieren dann Hydroxyalkylphenon-Derivate, deren Hydroxylgruppen zum einen mit Acrylsäure bzw. Acrylsäurederivaten verestert sind, die aber zum anderen in para-Stellung am Phenylring über Sauerstoff, Schwefel, Stickstoff und/oder eine oder mehrere Oxyethylen-Brücken Acryloylreste tragen.

Auch hier sind solche Verbindungen bevorzugt, in denen die übrigen Substituenten $R^1$ und $R^2$ Methyl sind. Als entsprechende Fotoinitiatoren sind beispielhaft anzuführen:

(4-Acryloyloxyphenyl)-2-acryloyloxy-2-propylketon
(4-Methacryloyloxyphenyl)-2-methacryloyloxy-2-propylketon
[4-(2-Acryloyloxyethoxy)-phenyl]-2-acryloyloxy-2-propylketon
[4-(2-Acryloyloxydiethoxy)-phenyl]-2-acryloyloxy-2-propylketon.

Besonders bevorzugte erfindungsgemäße Fotoinitiatoren sind die Verbindungen:

Phenyl-2-acryloyloxy-2-propylketon
(4-Acryloyloxyphenyl)-2-hydroxy-2-propylketon
(4-Acryloyloxyphenyl)-2-acryloyloxy-2-propylketon
[4-(2-Acryloyloxyethoxy)-phenyl]-2-hydroxy-2-propylketon
[4-(2-Acryloyloxyethoxy)-phenyl]-2-acryloyloxy-2-propylketon.

Die Verbindungen der allgemeinen Formel I können nach Standardverfahren der organischen Chemie hergestellt werden. Die Reaktionsbedingungen hierbei können den Standardwerken der präparativen organischen Chemie entnommen werden, z. B. HOUBEN-WEYL, Methoden der organischen Chemie, Georg-Thieme Verlag, Stuttgart, oder ORGANIC SYNTHESIS, J. Wiley, New York London Sydney.

Generell ist es günstig, die erfindungsgemäßen Fotoinitiatoren oder deren Vorstufen nach den bewährten Synthesemethoden, wie sie für die bekannten Hydroxyalkylphenon-Fotoinitiatoren gängig sind, herzustellen. Diese Methoden sind ausführlich in der DE-OS 27 22 264 beschrieben. Verbindungen der Formel I, in denen der Rest $R^3$ die ungesättigte Gruppe Z darstellt, lassen sich einfach aus handelsüblichen oder nach den bekannten Methoden hergestellten Hydroxyalkylphenonen durch Veresterung, beispielsweise mit Acrylsäurehalogenid und einem üblichen Veresterungskatalysator, vorzugsweise einem tertiären Amin, erhalten. So läßt sich etwa der erfindungsgemäße Initiator Phenyl-2-acryloyloxy-2-propylketon aus Phenyl-2-hydroxy-2-propylketon (Phenyl-2-hydroxy-2-methyl-propan-1-on; Darocur® 1173, Fa. E. Merck) durch Veresterung mit Acrylsäurechlorid/Triethylamin herstellen.

Verbindungen der Formel I, in denen $R^4$ die ungesättigte Gruppe Z enthält, können etwa in der Weise erhalten werden, daß man geeignete Phenylderivate, die Z oder eine Gruppierung, in die leicht Z einführbar

ist, enthalten, zur Einführung der Fotoinitiatorwirkstruktur oder einer Vorstufe hiervon mit einem entsprechenden Carbonsäurehalogenid nach Friedel-Crafts acyliert.

Als Ausgangsstoffe geeignete Phenylderivate lassen sich beispielsweise Phenol, 4-Thiophenol, 4-Aminophenol sowie ein- oder mehrfach ethoxyliertes Phenol wie 2-Hydroxyethylphenylether einsetzen.

Für die Friedel-Crafts-Acylierung empfiehlt es sich, die terminalen funktionellen Gruppen durch geeignete, später wieder entfernbare Schutzgruppen zu schützen, etwa *durch Acylierung im Falle der OH-Gruppe. Nach Einführung der Fotoinitiatorwirkstruktur kann dann die terminale OH-Gruppe etwa mit Acrylsäure in üblicher Weise verestert werden.

Als Phenylderivate, die die ungesättigte Gruppe Z schon enthalten, können aber auch Phenylacrylat, Phenylmethacrylat oder terminal acryliertes, ein- oder mehrfach ethoxyliertes Phenol wie Acryloyloxyethylphenylether verwendet werden. Bei diesen Ausgangsstoffen besteht allerdings die Gefahr einer vorzeitigen Polymerisation während der nachfolgenden Reaktionen.

Zur Erzeugung der Fotoinitiatorwirkstruktur des Hydroxyalkylphenontyps kann beispielsweise mit Isobuttersäurehalogenid oder α-Chlorisobuttersäurehalogenid acyliert und anschließend die Hydroxy-, Alkoxy-, oder Alkanoyloxygruppierung eingeführt werden.
So führt beispielsweise die Friedel-Crafts-Acylierung von acyliertem 2-Hydroxyethylphenylether mit Isobuttersäurechlorid und die anschließende Bromierung und Verseifung am tertiären C-Atom zu der Verbindung [4-(2-Hydroxyethoxy)-phenyl]-2-hydroxy-2-propylketon. Aus dieser Verbindung läßt sich etwa durch selektive Veresterung mit Acrylsäurechlorid/tertiäre Amine der erfindungsgemäße Initiator [4-(2-Acryloyloxyethoxy)-phenyl]-2-hydroxy-2-propylketon sowie durch Veresterung beider OH-Gruppen der erfindungsgemäße Initiator [4-(2-Acryloyloxyethoxy)-phenyl]-2-acryloyloxy-2-propylketon erhalten.

Wenn die Verknüpfung des ungesättigten Restes $R^4$ am Aromaten über Schwefel (X = S) erfolgt, ist eine Substitution entsprechender 4-Halogenarylketone mit Thiolen wie 2-Mercaptoethanol unter basischen Bedingungen möglich. N,N-Disubstituierte Aniline (X = N) lassen sich unter Vilsmeier-Bedingungen, z. B. mit Isobuttersäure-N,N-dimethylamid und Phosphoroxichlorid acylieren. Durch Veresterung der OH-Gruppen mit ungesättigten Säurechloriden werden die entsprechenden copolymerisierbaren Fotoinitiatoren erhalten.

Die Verbindungen der allgemeinen Formel I sind hochwirksame Fotoinitiatoren und können generell in fotopolymerisierbaren Systemen eingesetzt werden, sofern in diesen ethylenisch ungesättigte, fotopolymerisierbare Verbindungen enthalten sind.

Die erfindungsgemäßen Fotoinitiatoren besitzen, bedingt durch den oder die speziellen, ungesättigten Substituenten Z, die Eigenschaft, daß sie bzw. ihre in der Fotoinitiatorreaktion entstandenen Abbauprodukte als copolymerisierbare Comonomere in der Fotopolymerisationsreaktion fungieren können. Dies führt in überraschender Weise, wie in dem im Rahmen der nachfolgenden Beispiele wiedergegebenen Versuch gezeigt, zu einem unerwartet hohen Maß an Einbau der unumgesetzten Fotoinitiatoren bzw. der Fotoinitiatorabbauprodukte in das letztendlich erhaltene Polymerprodukt. Hierdurch lassen sich seht wirksam unerwünschte Einflüsse auf die Eigenschaften des Endproduktes vermindern bzw. gänzlich eliminieren. Weiterhin konnte festgestellt werden, daß mit der Einführung der ungesättigten Substituenten Z in die Hydroxyalkylphenon-Fotoinitiatorstruktur praktisch keine Wirksamkeitseinbuße eintritt.

Die Verbindungen der allgemeinen Formel I können erfindungsgemäß als Fotoinitiatoren für die Fotopolymerisation ethylenisch ungesättigter Verbindungen bzw. für die Härtung fotopolymerisierbarer Systeme, die solche Verbindungen enthalten, und insbesondere auch als UV-Härter für Druckfarben und bei der Strahlungshärtung wäßriger Prepolymerdispersionen verwendet werden. Diese Verwendung erfolgt in üblicher Weise. Die erfindungsgemäß anzuwendenden Verbindungen werden den zu polymerisierenden Systemen in der Regel in Mengen von 0,1 bis 20 Gew.%, vorzugsweise 0,5 bis 12 Gew.% zugesetzt.

Dieser Zusatz geschieht in der Regel durch einfaches Lösen und Einrühren, da die meisten der erfindungsgemäß zu verwendenden Fotoinitiatoren flüssig oder in den zu polymerisierenden Systemen zumindest gut löslich sind. Unter einem zu polymerisierenden System wird ein Gemisch von durch freie Radikale initiierbaren mono- oder polyfunktionellen ethylenisch ungesättigten Monomeren, Oligomeren, Prepolymeren, Polymeren oder Mischungen dieser Oligomeren, Prepolymeren und Polymeren mit ungesättigten Monomeren verstanden, das, falls erforderlich oder erwünscht, weitere Zusätze wie z. B. Antioxidantien, Lichtstabilisatoren, Farbstoffe, Pigmente, aber auch weitere bekannte Fotoinitiatoren sowie Reaktionsbeschleuniger enthalten kann. Als ungesättigte Verbindungen kommen alle diejenigen infrage, deren C=C-Doppelbindungen durch z. B. Halogenatome, Carbonyl-, Cyano-, Carboxy-, Ester-, Amid-, Ether- oder Arylgruppen oder durch konjugierte weitere Doppel- oder Dreifachbindungen aktiviert sind. Beispiele für solche Verbindungen sind Vinylchlorid, Vinylidenchlorid, Acrylnitril, Methacrylnitril, Acrylamid, Methacrylamid, Methyl-, Ethyl-, n-oder tert. Butyl-, Cyclohexyl-, 2-Ethylhexyl-, Benzyl-, Phenyloxyethyl-, Hydroxyethyl-, Hydroxypropyl-, niederes Alkoxyethyl-, Tetrahydrofurfurylacrylat oder -methacrylat, Vinylacetat, -propionat, -acrylat, -succinat, N-Vinylpyrrolidon, N-Vinylcarbazol, Styrol, Divinylbenzol, substituierte Styrole, sowie die

Mischungen von solchen ungesättigten Verbindungen. Auch mehrfach ungesättigte Verbindungen wie beispielsweise Ethylendiacrylat, 1,6-Hexandioldiacrylat, propoxyliertes Bisphenol-A-diacrylat und -dimethacrylat, Trimethylolpropandiacrylat und Pentaerythrittriacrylat können mit den erfindungsgemäß verwendeten Fotoinitiatoren polymerisiert werden. Als fotopolymerisierbare Verbindungen kommen weiterhin ungesättigte Oligomere, Prepolymere oder Polymere und deren Mischungen mit ungesättigten Monomeren in Frage. Hierzu zählen beispielsweise ungesättigte Polyester, ungesättigte Acrylmaterialien, Epoximaterialien, Urethane, Silikone, Aminopolyamid-Harze und insbesondere acrylierte Harze wie acryliertes Silikonöl, acrylierte Polyester, acrylierte Urethane, acrylierte Polyamide, acryliertes Sojabohnenöl, acryliertes Epoxiharz, acryliertes Acrylharz, zweckmäßig im Gemisch mit einem oder mehreren Acrylaten eines Mono-, Di- oder Polyalkohols.

Die fotopolymerisierbaren Verbindungen oder Systeme können durch den Zusatz bekannter thermischer Inhibitoren und Antioxidantien, wie beispielsweise Hydrochinon oder Hydrochinonderivate, Pyrogallol, Thiophenole, Nitroverbindungen, β-Naphthylamine oder β-Naphthole in den üblichen Mengen stabilisiert werden, ohne daß dadurch die Initiatorwirkung der erfindungsgemäßen Fotoinitiatoren nennenswert beeinträchtigt wird. Durch solche Zusätze soll vor allem eine vorzeitige Polymerisation während der Herstellung der Systeme durch Mischen der Komponenten verhindert werden.

Weiterhin können geringe Mengen von Lichtstabilisatoren, wie beispielsweise Benzophenon-Derivate, Benztriazol-Derivate, Tetraalkylpiperidine oder Phenylsalicylate, zugesetzt werden.

Um die inhibierende Wirkung des Luftsauerstoffs auszuschließen, setzt man fotopolymerisierbaren Systemen häufig auch Paraffin oder ähnliche wachsartige Stoffe zu. Infolge mangelnder Löslichkeit im Polymeren schwimmen diese bei Beginn der Polymerisation aus und bilden eine transparente Oberflächenschicht, die den Zutritt von Luft verhindert. Der Luftsauerstoff kann beispielsweise auch durch Einführung von autoxidablen Gruppen, wie z. B. Allylgruppen, in das zu härtende System desaktiviert werden.

Die erfindungsgemäßen Fotoinitiatoren können auch in Kombination mit bekannten radikalischen Initiatoren, wie beispielsweise Peroxiden, Hydroperoxiden, Ketonperoxiden oder Percarbonsäureestern verwendet werden. Weiterhin können sie Pigmente oder Farbstoffe, wie sie z. B. in fotochemisch aushärtenden Druckfarben gebräuchlich sind, enthalten. In diesem Fall wird die Fotoinitiatormenge höher gewählt, beispielsweise 6 bis 12 Gew.%, während für farblose fotopolymerisierbare Produkte 0,1 bis 5 Gew.% in den meisten Fällen voll ausreichen. Je nach Verwendungszweck können Füllstoffe, wie Talkum, Gips oder Kieselsäure, Fasern, organische Zusatzstoffe wie Thixotropiemittel, Verlaufsmittel, Bindemittel, Gleitmittel, Mattierungsmittel, Weichmacher, Netzmittel, Silikone zur Verbesserung der Oberflächenbeschaffenheit, Antiausschwimmittel oder untergeordnete Mengen an Lösungsmitteln zugesetzt werden.

Als gegebenenfalls zusammen mit den erfindungsgemäßen Initiatoren verwendbare bekannte Fotoinitiatoren kommen beispielsweise infrage Benzophenone wie z. B. Michlers Keton [4,4′-Bis(dimethylamino)-benzophenon], 4,4′-Bis(diäthylamino)benzophenon, p-Dimethylaminobenzophenon, p-Chlorbenzophenon, Benzophenon; Anthrachinone wie z. B. Anthrachinon, 2-Chloranthrachinon, 2-Alkylanthrachinone; Xanthone wie z. B. 2-Halogenxanthone oder 2-Alkylxanthone; Thioxanthone wie 2-Chlorthioxanthon, 2-Alkylthioxanthone; Acridanone wie z. B. 2-Alkylacridanone oder N-substituierte Acridanone; Benzoine wie z. B. p-Dimethylaminobenzoin und Alkylether des Benzoins; Benzilketale, α-Halogenketone, Dialkoxyacetophenone, α-Hydroxyalkylphenone und α-Aminoalkylphenone wie sie beispielsweise in der DE-OS 27 22 264 und in der EP-OS 3002 beschrieben sind, weiterhin z. B. Fluorenone, Dibenzosuberone, Phenanthrenchinone, Benzoesäureester wie z. B. Hydroxypropylbenzoat, Benzoylbenzoatacrylat.

Gemische mit bekannten Initiatoren enthalten die erfindungsgemäß anzuwendenden copolymerisierbaren Fotoinitiatoren in der Regel in Anteilen von mindestens 10 Gew.%, vorteilhafterweise von 50 bis 95 Gew.%, bezogen auf die Gesamtmenge an eingesetzter Initiatormischung.

Es ist vorteilhaft, neben den erfindungsgemäßen copolymerisierbaren Fotoinitiatoren in den fotopolymerisierbaren Systemen Reaktionsbeschleuniger einzusetzen.

Als Reaktionsbeschleuniger können beispielsweise organische Amine, Phosphine, Alkohole und/oder Thiole, die alle mindestens eine zum Heteroatom α-ständige CH-Gruppe aufweisen, zugesetzt werden. Geeignet sind z. B. primäre, sekundäre und tertiäre aliphatische, aromatische, araliphatische oder heterocyclische Amine, wie sie z. B. in der US-PS 3,759,807 beschrieben sind. Beispiele für solche Amine sind Butylamin, Dibutylamin, Tributylamin, Cyclohexylamin, Benzyldimethylamin, Di-cyclohexylamin, Triethanolamin, N-Methyldiethanolamin, Phenyl-diethanolamin, Piperidin, Piperazin, Morpholin, Pyridin, Chinolin, p-Dimethylaminobenzoesäureethylester, p-Dimethylaminobenzoesäurebutylester, 4,4′-Bis(dimethylamino)-benzophenon (Michlers Keton) oder 4,4′-Bis(diethylamino)benzophenon. Besonders bevorzugt sind tertiäre Amine wie beispielsweise Trimethylamin, Tri-isopropylamin, Tributylamin, Octyldimethylamin, Dodecyl-dimethylamin, Triethanolamin, N-Methyl-diethanolamin, N-Butyl-diethanolamin, Tris(hydroxypropyl)amin, Dimethylaminobenzoesäurealkylester. Weiterhin kommen als Reaktionsbeschleuniger beispielsweise Trialkylphosphine, sekundäre Alkohole und Thiole in Frage. Der Zusatz derartiger Reaktionsbeschleuniger kann sich in den für sie üblichen Mengen bewegen.

Fotopolymerisierbare Systeme, die zusätzlich als Reaktionsbeschleuniger ein tertiäres organisches Amin enthalten, stellen eine besonders bevorzugte Form der vorliegenden Erfindung dar.

Der Ausdruck "Fotopolymerisation von ethylenisch ungesättigten Verbindungen" ist im weitesten Sinn zu verstehen. Darunter fällt z. B. auch das weitere Polymerisieren oder das Quervernetzen von polymeren Materialien, etwa von Prepolymeren, die Homo-, Co- und Terpolymerisation von einfachen Monomeren und auch die Kombination der genannten Reaktionsarten.

Durch die Einwirkung von energiereicher Strahlung, vorzugsweise UV-Licht, auf die die erfindungsgemäßen copolymerisierbaren Fotoinitiatoren enthaltenden fotopolymerisierbaren Systemen kann die Fotopolymerisation ausgelöst werden. Die Fotopolymerisation erfolgt nach an sich bekannten Methoden durch Bestrahlen mit Licht oder UV-Strahlung des Wellenlängenbereichs von 250-500 nm, vorzugsweise von 300-400 nm. Als Strahlenquellen können Sonnenlicht oder künstliche Strahler verwendet werden. Vorteilhaft sind zum Beispiel Quecksilberdampf-Hochdruck-, -Mitteldruck- oder -Niederdrucklampen sowie Xenon- und Wolframlampen.

Die Durchführung der Fotopolymerisation unter Verwendung der erfindungsgemäßen Fotoinitiatoren kann sowohl diskontinuierlich als auch kontinuierlich geschehen. Die Bestrahlungsdauer hängt von der Art der Durchführung, von der Art und Konzentration der eingesetzten polymerisierbaren Materialien, von Art und Menge der verwendeten Fotoinitiatoren und von der Intensität der Lichtquelle ab und kann, wie beispielsweise bei der Strahlungshärtung von Beschichtungen, im Bereich weniger Sekunden bis Minuten, bei Großansätzen, wie beispielsweise bei der Massepolymerisation, aber auch im Stundenbereich liegen.

Die erfindungsgemäßen Verbindungen der Formel I werden bevorzugt verwendet als Fotoinitiatoren bei der UV-Härtung von dünnen Schichten wie beispielsweise Lackbeschichtungen auf allen hierfür üblichen Materialien und Trägern. Diese können vornehmlich sein Papier, Holz, textile Träger, Kunststoff und Metall, Ein wichtiges Anwendungsgebiet ist auch die Trocknung bzw. Härtung von Druckfarben und Siebdruckmaterialien, von denen letztere bevorzugt bei der Oberflächenbeschichtung bzw. -gestaltung von beispielsweise Dosen, Tuben und metallenen Verschlußkappen eingesetzt werden. Aufgrund der weitestgehenden bis völligen Abwesenheit freier Initiatorreste in mit den erfindungsgemäßen copolymerisierbaren Fotoinitiatoren versetzten Systemen nach erfolgter Fotopolymerisation sind diese besonders geeignet in Anwendungsgebieten, wo eine Diffusion derartiger Reste in entsprechende Endprodukte umgebende Medien ausgeschlossen werden soll, beispielsweise wenn mit fotopolymerisierten Beschichtungen versehene Verpackungsmittel mit Lebensmitteln in Berührung kommen.

Die nachfolgenden Beispiele 1-5 beschreiben die Herstellung erfindungsgemäßer copolymerisierbarer Fotoinitiatoren.

Beispiel 1

Phenyl-2-acryloyloxy-2-propylketon

Zu 5,0 g (0,03 mol) handelsüblichem Phenyl-2-hydroxy-2-propylketon in 40 ml Dioxan werden unter Inertgasschutz 5,4 g (0,06 mol) Acrylsäurechlorid zugegeben und dann wird unter Rühren eine Mischung aus 6,1 g (0,06 mol) Triethylamin und 5 ml Dioxan zugetropft. Danach wird noch eine Stunde bei Rückflußtemperature gekocht und nach Abkühlung das Reaktionsgemisch in 300 ml Eiswasser gegeben. Durch Extraktion mit Essigester, Entfernung des Lösungsmittels und Umkristallisation aus Methyl-t-butylether erhält man 3,2 g des Fotoinitiators mit Schmelzpunkt 89 °C.

Analog wird hergestellt: Phenyl-2-methacryloyloxy-2-propylketon.

Beispiel 2

[4-(2-Acryloyloxyethoxy)-phenyl]-2-hydroxy-2-propylketon

a) Zu 880 g (6,6 mol) wasserfreiem Aluminiumchlorid in 480 ml Dichlormethan werden bei -5 bis 0 °C 336 g (3,2 Mol) Isobuttersäurechlorid innerhalb von 40 Minuten unter Rühren zugetropft. Danach werden bei der gleichen Temperatur 540 g (3,0 Mol) 2-Phenoxyethylacetat innerhalb von 2 Stunden zugetropft. Man rührt nach der Beendigung des Zutropfens noch weitere 2 Stunden bei der angegebenen Temperatur und gießt die Reaktionsmischung dann in ein Gemisch aus 1,8 1 konzentrierter Salzsäure und 5 kg Eis. Die organische Phase wird abgetrennt und die wäßrige Schicht wird mit Dichlormethan extrahiert. Die vereinigten organischen Phasen werden mit Wasser gewaschen, getrocknet, eingeengt

und der Rückstand wird im Vakuum destilliert. Man erhält 740 g [4-(2-Acetoxyethoxy)-phenyl]-2-propylketon mit Siedepunkt 145-152 °C/0,3-0,5 Torr.

b) 250 g (1,0 Mol) [4-(2-Acetoxyethyloxy)-phenyl]-2-propylketon werden in 200 ml Eisessig gelöst und unter Rühren bei 25 °C innerhalb von 2 Stunden mit 192 g (1,2 Mol) Brom versetzt. Es wird ca. 10 Stunden nachgerührt und dann in 3 l Eisessig eingegossen. Das Produkt wird mit Essigsäureethylester extrahiert. Die vereinigten Extrakte werden getrocknet und durch Einengen erhält man 365 g eines dickflüssigen Öles. Dieses wird in 1 l Ethanol gelöst und unter Rühren bei 25 °C innerhalb von 20 Minuten mit 380 g 32 %iger Natronlauge versetzt. Es wird 10 Minuten nachgerühurt und dann das Ethanol entfernt. Der ölige Rückstand wird in 3 l Eiswasser gegeben, und diese Mischung extrahiert man mehrmals mit insgesamt 1,5 l Essigsäureethylester. Nach dem Trocknen, Filtrieren und Einengen der Lösung werden 250 g öliges Rohprodukt isoliert. Durch Umkristallisation aus Aceton/Petrolether und/oder chromatographische Aufreinigung erhält man 145 g [4-(2-Hydroxyethoxy)-phenyl]-2-hydroxy-2-propylketon in Form einer farblosen Festsubstanz von Schmelzpunkt 88-90 °C.

c) 27,0 g (0,12 mol) [4-(2-Hydroxyethoxy)-phenyl]-2-hydroxy-2-propylketon werden in 240 ml Dioxan gelöst. Dann werden unter Rühren bei Raumtemperatur zunächst 12,0 g (0,132 mol) Acrylsäurechlorid in 20 ml Dioxan und anschließend 16,8 g (0,132 mol) Chinolin in 20 ml Dioxan zugetropft. Es wird 1 h bei 50 °C nachgerührt, abgekühlt und auf 1 l Eiswasser gegossen. Das Gemisch wird 3 mal mit je 250 ml Essigsäureethylester extrahiert. Nach dem Trocknen und Einengen der organischen Phase werden 20,8 g des Fotoinitiators in Form eines dickflüssigen Öles erhalten.

$^1$H-NMR ($CDCl_3$): $\delta$ 1,6 (s, 6 H, 2 $CH_3$); 4,3 (m, 2 H, $CH_2$); 4,6 (m, 2 H, $CH_2$); 5,3 (s. 1 H, OH); 5,9-6,5 (m, 3 olef. H); 7,0 (m, 2 arom. H); 8,1 (m, 2 arom. H) ppm.
IR: $\nu$ 1710 (CO): 3500 (OH) $cm^{-1}$.

Analog wird hergestellt:

[4-(2-Methacryloyloxyethoxy)-phenyl]-2-hydroxy-2-propylketon.

$^1$H-NMR ($CDCl_3$): $\delta$ 1,6 (s, 6H, 2 $CH_3$); 2,0 (s, 3 H, $CH_3$); 4,3 (t, 2 H, $CH_2$); 4,5 (t, 2 H, $CH_2$), 5,6 (s, 1 olef. H); 6,2 (s, 1 olef. H); 7,0 (d, 2 arom.H); 8,1 (d, 2 arom. H) ppm.

[4-(2-Acryloyloxyethylthio)phenyl]-2-hydroxy-2-propylketon.

$^1$H-NMR (($CDCl_3$): $\delta$ 1,6 (s, 6 H, 2 $CH_3$); 3,3 (t, 2 H, $CH_2$); 4,4 (t, 2 H $CH_2$); 5,8 bis 6,4 (m, 3 olef. H); 7,4 (d, 2 arom. H); 8,0 (d, 2 arom. H) ppm.

## Beispiel 3

[4-(2-Acryloyloxyethoxy)-phenyl]-2-acryloyloxy-2-propylketon

27,0 g (0,12 mol) des in Beispiel 2a erhaltenen [4-(2-Hydroxyethoxy)-phenyl]-2-hydroxy-2-propylketon werden mit 24,0 g (0,264 mol) Acrylsäurechlorid und 26,4 g (0,264 mol) Triethylamin verestert. Nach entsprechender Aufarbeitung erhält man 22,8 g des Fotoinitiators mit Schmelzpunkt 71 °C.

## Beispiel 4

(4-Acryloyloxyphenyl)-2-hydroxy-2-propylketon

Zu einer Lösung von 2,2 g (0,012 mol) (4-Hydroxyphenyl)-2-hydroxy-2-propylketon in 20 ml wasserfreiem Tetrahydrofuan werden unter Rühren bei Raumtemperatur portionsweise 0,4 g (0,014 mol) Natriumhydrid (80 %ig in Paraffinöl) gegeben. Nach 15 min werden 1,2 g (0,013 mol) Acrylsäurechlorid in 5 ml wasserfreim Tetrahydrofuran in 10 min zugetropft und danach wird noch 1 Stunde gerührt. Nach der Aufarbeitung (s. Beispiel 2 c) werden 2, 5 g eines dickflüssigen, farblosen Öles erhalten.

$^1$H-NMR($CDCL_3$): $\delta$ 1,5 (s, 6 H, 2 $CH_3$); 6,0 bis 6,6 (m, 3 olef. H); 7,1 (m, 2 arom. H); 8,0 (m, 2 arom. H) ppm.

Analog wird hergestellt: (4-Methacryloxphenyl)-2-hydroxy-2-propylketon.

$^1$H-NMR ($CDCL_3$): $\delta$ 1,6 (s, 6H, 2 $CH_3$); 2,1 (s, 3 H, $CH_3$); 5,8 (s, 1 olef. H); 7,3 (d, 2 arom. H); 8,1 (d, 2

arom.H) ppm.

Beispiel 5

(4-Acryloyloxyphenyl)-2-acryoyloxy-2-propylketon

2,2 g (0,012 mol) (4-Hydroxphenyl)-2-hydroxy-2-propylketon, 2,4 g (0,027 mol) Acrylsäurechlorid und 2,7 g (0,027 mol) Triethylamin werden in 30 ml Dioxan wie in Beispiel 3 umgesetzt und aufgearbeitet. Es werden 3,6 g eines weißen, kristallinen Produktes vom Schmelzpunkt 90-93 °C (umkristallisiert aus Cyclohexan) erhalten.

Analog wird hergestellt: (4-Methacryloyloxyphenyl)-2-methacryloyloxy-2-propylketon.

$^1$H-NMR ($CDCl_3$): 1,8 (s, 6 H, 2 $CH_3$); 5,8 bis 6,7 (m, 6 olef. H); 7,2 (d, 2 arom. H); 8,1 (d, 2 arom. H) ppm.

Die nachfolgenden Beispiele 6-9 beschreiben die Verwendung der erfindungsgemäßen copolymerisierbaren Fotoinitiatoren in strahlungshärtbaren Bindemittelsystemen.

Beispiel 6

Ein UV-härtbares Bindemittelsystem, das aus 75 Gew.-Teilen eines oligomeren Epoxidacrylates (Laromer® LR 8555 der Fa. BASF) und 25 Gew.-Teilen Hexandioldiacrylat besteht, wird mit 5 Gew.-Teilen Phenyl-2-acryloyloxy-2-propylketon (Initiator nach Beispiel 1) versetzt.

Die gebrauchsfertige Formulierung wird auf entfettete Glasplatten (10 × 10 cm) mit Spiralrakeln in einer Dicke von 50 µm aufgebracht. Anschließend werden die Beschichtungen in einem Bestrahlungsgerät "Mini-Cure"-Gerät der Fa. Primarc Ltd.) unter einer Quecksilbermitteldrucklampe (Lampenleistung 80 Watt/cm) mit einer Bandgeschwindigkeit von 10 m/min gehärtet. Der Belichtungsabstand beträgt ca. 10 cm.

Die erhaltenen, voll ausgehärteten Beschichtungen sind völlig geruchfrei und zeigen keine Vergilbung.

In analoger Weise erhält man gleichermaßen gute Ergebnisse mit den Initiatoren der Beispiele 2-5.

Beispiel 7

Ein UV-Härtbares Bindemittelsystem, bestehend aus 60 Gew.-Teilen eines acrylierten Polyurethan-Prepolymers (Prepolymer VPS 1748, Fa. Degussa AG), 40 Gew.-Teilen Hexandioldiacrylat, 15 Gew.-Teilen Pentaerythrittriacrylat und 5 Gew.-Teilen [4-(2-Acryloyloxyethoxy)-phenyl]-2-hydroxy2-propylketon (Initiator nach Beispiel 2) wird analog zu Beispiel 6 zu 50 µm dicken Beschichtungen verarbeitet und bei einer Bandgeschwindigkeit von 30 m/min gehärtet. Die erhaltenen, voll ausgehärteten Beschichtungen sind völlig geruchfrei und farblos.

Die entsprechende Verwendung der Initiatoren nach Beispiel 1 sowie 3-5 ergibt gleichermaßen gute Ergebnisse.

Beispiel 8

63,5 Teilen eines Epoxidacrylatharzes (Laromer® 8555 der Firma BASF, Ludwigshafen) werden mit 36,5 Teilen Butandioldiacrylat und 20 Teilen Heliogenblau auf einer Dreiwalze angerieben. Innerhalb von 10 Minuten werden 5 Teile [4-(2-Acryloyloxyethoxy)-phenyl]-2-hydroxy-2-propylketon (Initiator nach Beispiel 2) in die Suspension eingerührt. Die so erhaltene Druckfarbe wird in 1 µm Schichtdicke auf Kunstdruckpapier verdruckt und bei einer Bandgeschwindigkeit von 50 m/min mit einer Strahlungsleistung von 160 W/cm ausgehärtet. Die erhaltenen geruchfreien Druckbogen sind sofort stapelfähig. Der Farbabstandsbewertung zufolge zeigt die blaue Bedruckung keine durch Vergilbung hervorgerufene Farbverschiebung.

Analog Beispiel 8 können die in den Beispielen 1 sowie 3-5 genannten Fotoinitiatoren als UV-Härter für Druckfarben verwendet werden.

Beispiel 9

63,5 Gew.-Teile eines Urethanacrylat-Harzes (Uvimer® 530 der Firma Bayer, Leverkusen) werden mit 36, 5 Gew.-Teilen Butandioldiacrylat und 100 Teilen Titandioxid (Anatas) in einer Porzellankugelmühle vermahlen. Anschließend werden 5 Gew.-Teile (4-Acryloyloxyphenyl)-2-hydroxy-2-propylketon (Initiator nach

Beispiel 4) und 3 Gew.-Teile N-Methyldiethanolamin eingerührt. Der in einer Schichtdicke von 10 µm auf Glasplatten aufgebrachte Lack läßt sich bei einer Bandgeschwindigkeit von 50 m/min und mit einer Strahlungsleistung von 160 W/cm einem geruchlosen, vergilbungsfreien Film aushärten.

Analog Beispiel 9 können die in den Beispielen 1 bis 3 und 5 genannten Verbindungen als Fotoinitiatoren in einen pigmentierten Lack eingearbeitet werden.

Der im nachfolgenden Beispiel 10 wiedergegebene Versuch zeigt die Vorteile der erfindungsgemäßen copolymerisierbaren Fotoinitiatoren im Vergleich zu bekannten Fotoinitiatoren hinsichtlich Restgehalt an Initiator in der fotopolymerisierten Schicht bei unter optimalen Bedingungen erzielbarer Endhärte der Schicht.

Beispiel 10

Versuch

Es wurde ein UV-härtbares Bindemittelsystem zubereitet, bestehend aus

75 Gew.% eines Prepolymeren auf Basis eines acrylierten Epoxidharzes (Laromer® EA 81, Fa. BASF AG),

25 Gew.% Hexandioldiacrylat.

Gleiche Anteile dieses Bindemittelsystems wurden mit jeweils 5 Gew. % der folgenden Fotoinitiatoren versetzt:

Nr. 1 [4-(2-Acryloxyloxyethoxy)-phenyl]-2-hydroxy-2-propylketon (erfindungsgemäßer Initiator nach Beispiel 2)

Nr. 2 Phenyl-2-hydroxy-2-propylketon (Darocur® 1173, Fa. E. Merck; zum Vergleich)

Nr. 3 α-Allylbenzoin (zum Vergleich)

Nr. 4 α-Allylbenzoinallylether (zum Vergleich).

Proben der homogenen, gebrauchsfertigen UV-Lacke wurden in bekannter Weise mit einer Spiralrakel auf Glasplatten (10 x 10) zu Schichten von 50 µm ausgezogen. In Vorversuchen wurden für diese Lackbeschichtungen zunächst die Bedingungen für eine optimale Härtung ermittelt. Hierzu wurden die beschichteten Platten in einem UV-Labortrockner (Beltrolux, Fa. Beltron) auf einem Transportband variabler Geschwindigkeit (2,5 bis 40 m/min) in einem Belichtungsabstand von etwa 1 cm unter 2 Quecksilbermitteldrucklampen von jeweils 50 Watt/cm Strahlungsleistung vorbeigeführt. Am Tag nach der UV-Härtung wurde die jeweils erzielte Schichthärte durch Bestimmung der Pendelhärte nach König (DIN 53157) ermittelt.

Die Härtebestimmung nach dieser Norm beruht darauf, daß die Schwingung eines sich auf die Schicht aufstützenden Pendels umso stärker gedämpft wird, je weicher die Schicht ist. Als Maß für die Pendelhärte gilt die Zeitspanne in Sekunden, in der die Auslenkung des schwingenden Pendels von 6° auf 3° zur Senkrechten ablingt. Je länger die Dämpfungsdauer, umso härter ist die Schicht.

Für die mit den vorliegenden UV-härtbaren Bindemittelsystemen erzeugten Beschichtungen ergab sich als erzielbare Endhärte ein Pendelhärte von 210 Sekunden, welche sich im Falle der Initiatoren Nr. 1 (erfindungsgemäßer Initiator) und Nr. 2 bei einen maximalen Bandgeschwindigkeit von 10 m/min (entspricht einer Mindestbelichtungsdauer von 6 s/m), im Falle der Initiatoren Nr. 3 und Nr. 4 bei 5 m/min (12 s/m) erhalten ließ.

Zur Bestimmung der in diesen Beschichtungen nach der UV-Härtung noch vorhandenen Anteile an unumgesetztem Initiator wurden diese Schichten von den Trägern abgelöst, zerkleinert, Proben hiervon in Extraktionsgefäße exakt eingewogen und mit jeweils gleichen Mengen Acetonitril als Extraktionsmittel 2 Stunden lang im Ultraschallbad behandelt.

Die erhaltenen Lösungen wurden dann mittels Hochdruckflüssigchromatographie auf ihren Gehalt an Initiator untersucht.

Die nachfolgende Tabelle 1 zeigt für die mit den jeweiligen Fotoinitiatoren erhaltenen Beschichtungen (Pendelhärte 210 s) die jeweils extrahierbare Menge an Initiator (im ungehärteten Bindemittelsystem eingesetzte Menge am Initiator = 100 %).

Tabelle 1

| Initiator Nr. | UV-Härtung Bandgeschwindigkeit | extrahierbare Menge Initiator |
|---|---|---|
| 1 | 10 m/min | 6,5 % |
| 2 | 10 m/min | 66 % |
| 3 | 5 m/min | 40 % |
| 4 | 5 m/min | 26 % |

Ergebnis

Es zeigt sich, daß bei unter optimalen Bedingungen vorgenommener UV-Härtung die aus den mit den bekannten Initiatoren (Nr. 2, 3 und 4) erhaltenen Beschichtungen extrahierbaren Mengen an Initiator um den Faktor 4 bis 10 höher sind als im Falle der Härtung mit dem erfindungsgemäßen copolymerisierbaren Initiator (Nr. 1).

Dies läßt für den erfindungsgemäßen Initiator auf einen nahezu vollständigen Einbau in das Polymermaterial durch Copolymerisation schließen, was offensichtlich bei den bekannten Initiatoren, insbesondere auch bei den ungesättigten Allylbenzoinderivaten, nicht der Fall ist.

Es zeigt sich auch, daß der erfindungsgemäße Initiator in seiner Wirksamkeit mit dem bekannten Hydroxyalkylphenon-Initiator vergleichbar ist.

## Patentansprüche

**1.** Verbindungen der allgemeinen Formel I

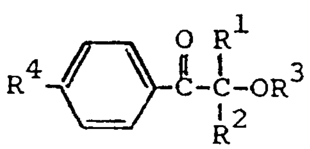

(I)

worin

| | |
|---|---|
| $R^1$ und $R^2$ | jeweils H, $C_{1-6}$-Alkyl |
| $R^3$ | H, $C_{1-6}$-Alkyl, $C_{1-6}$-Alkanoyl oder die Gruppe Z, |
| $R^4$ | H, Halogen, $C_{1-12}$-Alkyl, $C_{1-12}$-Alkoxy, $C_{1-12}$-Alkylthio oder die Gruppe $-x[(CH_2-CH_2-O)_n-Z]_m$ |

und

| | |
|---|---|
| X | O, S oder N |
| n | die Zahlen 0 bis 4, |
| m | die Zahl 1 für X = O und S oder die Zahlen 1 und 2 für X = N |
| Z | die Gruppe -CO-CR=CR'R" mit R, R', R" jeweils H oder $CH_3$ |

bedeuten,
wobei immer mindestens einer der Reste $R^3$ oder $R^4$ die Gruppe Z enthält.

**2.** Verwendung der Verbindungen der Formel I als copolymerisierbare Fotoinitiatoren für die Fotopolymerisation ethylenisch ungesättigter Verbindungen.

**3.** Verwendung der Verbindungen der Formel I, gegebenenfalls zusammen mit bekannten Fotoinitiatoren und/oder Sensibilisatoren, als copolymerisierbare Fotoinitiatoren für die Fotopolymerisation ethylenisch ungesättigter Verbindungen oder solche enthaltender Systeme.

**4.** Verwendung nach Anspruch 3 in UV-härtenden Druckfarben.

5. Verwendung nach Anspruch 3 bei der Strahlungshärtung wäßriger Präpolymerdispersionen.

6. Verfahren zur Fotopolymerisation ethylenisch ungesättigter Verbindungen oder solche enthaltender Systeme, dadurch gekennzeichnet, daß man dem zu polymerisierenden Gemisch vor der Auslösung der Fotopolymerisation mindestens eine Verbindung der Formel I als copolymerisierbaren Fotoinitiator zusetzt.

7. Verfahren nach Anspruch 6, dadurch gekennzeichnet, daß man dem zu polymerisierenden Gemisch vor der Auslösung der Fotopolymerisation 0,1 bis 20 Gew.% einer Verbindung der Formel I zusetzt.

8. Fotopolymerisierbare Systeme, enthaltend mindestens eine ethylenisch ungesättigte fotopolymerisierbare Verbindung sowie gegebenenfalls weitere bekannte und übliche Zusatzstoffe, dadurch gekennzeichnet, daß sie mindestenvs eine Verbindung der Formel I als copolymerisierbaren Fotoinitiator enthalten.

9. Fotopolymerisierbares System nach Anspruch 8, dadurch gekennzeichnet, daß es 0,1 bis 20 Gew.% einer Verbindung der Formel I enthält.

## Claims

1. Compounds of the general formula I

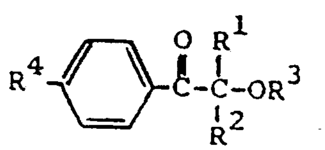

(I)

in which

$R^1$ and $R^2$ are each H or $C_1$-$C_6$-alkyl,
$R^3$ is H, $C_1$-$C_6$-alkyl, $C_1$-$C_6$-alkanoyl or the group Z,
$R^4$ is H, halogen, $C_1$-$C_{12}$-alkyl, $C_1$-$C_{12}$-alkoxy, $C_1$-$C_{12}$-alkylthio or the group $-[X(CH_2-CH_2-O)_n-Z]_m$

and

X is O, S or N
n is the numbers 0 to 4,
m is the number 1 for X = O and S or the numbers 1 and 2 for X = N
Z is the group -CO-CR=CR'R" with R, R', R" each being H or $CH_3$,

always at least one of the radicals $R^3$ or $R^4$ containing the group Z.

2. Use of the compounds of the formula I, as copolymerizable photoinitiators for the photopolymerization of ethylenically unsaturated compounds.

3. Use of the compounds of the formula I, where appropriate together with known photoinitiators and/or sensitizers, as copolymerizable photoinitiators for the photopolymerization of ethylenically unsaturated compounds or systems containing such compounds.

4. Use according to Claim 3, in UV-hardening printing inks.

5. Use according to Claim 3, in the radiation hardening of aqueous prepolymer dispersions.

6. Process for photopolymerizing ethylenically unsaturated compounds or systems containing such compounds, characterized in that at least one compound of the formula I is added as a copolymerizable photoinitiator to the mixture to be polymerized, before initiation of the photopolymerization.

7. Process according to Claim 6, characterized in that 0.1 to 20% by weight of a compound of the formula I is added to the mixture to be polymerized, before initiation of the photopolymerization.

8. Photopolymerizable systems containing at least one ethylenically unsaturated photopolymerizable compound and, where appropriate, further known and customary additives, characterized in that they contain at least one compound of the formula I as a copolymerizable photoinitiator.

9. Photopolymerizable system according to Claim 8, characterized in that it contains 0.1 to 20% by weight of a compound of the formula I.

**Revendications**

1. Composés de formule générale I

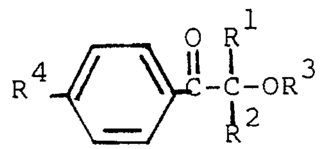

(I)

dans laquelle

- $R^1$ et $R^2$ représentent chacun H, un groupe alkyle en C1-C6,
- $R^3$ représente H, un groupe alkyle en C1-C6, alcanoyle en C1-C6 ou le groupe Z,
- $R^4$ représente H, un halogène, un groupe alkyle en C1-C12, alcoxy en C1-C12, alkylthio en C1-C12 ou le groupe $-X[(CH_2-CH_2-O)_n-Z]_m$ et
- X représente O, S ou N,
- n a une valeur de 0 à 4,
- m est égal à 1 lorsque X représente O ou S ou à 1 ou 2 lorsque X représente N,
- Z représente le groupe -CO-CR=CR'R"

dans lequel R, R', R" représentent chacun H ou $CH_3$, sous réserve qu'au moins un des substituants $R^3$ ou $R^4$ contient toujours le groupe Z.

2. Utilisation des composés de formule I en tant que photo-inducteurs copolymérisables pour la photopolymérisation de composés à insaturation éthylénique.

3. Utilisation des composés de formule I, éventuellement avec des photo-inducteurs et/ou sensibilisants connus, en tant que photo-inducteurs copolymérisables pour la photopolymérisation de composés à insaturation éthylénique ou de systèmes contenant de tels composés.

4. Utilisation selon la revendication 3 dans des encres d'impression durcissant aux UV.

5. Utilisation selon la revendication 3, pour le durcissement de dispersions aqueuses de prépolymères sous l'action de rayonnements.

6. Procédé pour la photopolymérisation de composés à insaturation éthylénique ou de systèmes contenant de tels composés, caractérisé en ce que, avant le déclenchement de la photopolymérisation, on ajoute au mélange à polymériser un composé de formule I en tant que photo-inducteur copolymérisable.

7. Procédé selon la revendication 6, caractérisé en ce que l'on ajoute au mélange à polymériser, avant le déclenchement de la photopolymérisation, de 0,1 à 20% en poids d'un composé de formule I.

8. Systèmes photopolymérisables, contenant au moins un composé à insaturation éthylénique photopolymérisable et le cas échéant d'autres additifs connus et usuels, caractérisés en ce qu'ils contiennent au moins un composé de formule I en tant que photo-inducteur copolymérisable.

9. Système photopolymérisable selon la revendication 8, caractérisé en ce qu'il contient de 0,1 à 20% en poids d'un composé de formule I.